# EUROPEAN PATENT APPLICATION

(11) **EP 1 710 560 A1**
(43) Date of publication of application: **11.10.2006**
(21) Application number: 05102743.1
(22) Date of filing: 07.04.2005
(51) Int. Cl.: G01N 21/33, H01J 37/32

(54) **A method of testing a plasma reactor**

(71) Applicant: CENTRE NATIONAL DE LA RECHERCHE SCIENTIFIQUE (CNRS), 75794 Paris Cedex 16 (FR); UNIVERSITE JOSEPH FOURIER, 38041 Grenoble Cédex 9 (FR)
(72) Inventor: Cunge, Gilles, 38600, Fontaine (FR); Mori, Masahito, 359-0024, Tokorozawa-shi (JP); Sadeghi, Nader, 38000 Grenoble (FR); Kogelschatz, Martin, 69118 Heidelberg (DE)
(74) Representative: de Beaumont, Michel

(57) **Abstract**

The invention concerns a method of testing a plasma reactor comprising:
a) introducing Cl₂,
b) creating a plasma,
c) after the plasma creation, measuring the Cl₂ concentration,
d) comparing the measured Cl₂ concentration with a reference Cl₂ concentration,
e) if said comparison indicates a deviation higher than a selected threshold, cleaning and possibly conditioning the reactor and repeating steps a) to d).

## Description

The present invention relates to plasma reactors used for processing semiconductor wafers, and more particularly for manufacturing integrated circuits.

In the manufacturing of integrated circuits from silicon wafers, plasma reactors are more and more used for plasma etching or plasma deposition. Various types of plasmas are used, in particular plasmas including chlorine and plasmas containing fluorine. Generally, a plasma reactor processes a single wafer at a time and a plurality of sequential operations are made on a same wafer. In the last technologies, the wafers are larger and larger, currently having a diameter of 300 mm. Diameters of 450 mm are planned in a close future. So, if a manufacturing step is faulty, or more precisely not conform to the previsions, all the integrated circuits being formed in such large wafers are lost and the manufacturing yield decreases dramatically.

In practice, parameter drifts appear when a same reactor is used in conditions that are theoretically identical. When such a drift occurs, costly wafers are lost and in addition the reactor must be opened for a wet clean operation thus decreasing the manufacturing yield. So, semiconductor manufacturers commonly use test wafers that are, from time to time, introduced in the plasma reactor and checked for controlling the process reproducibility. An important factor of variation of the plasma parameters is due to the deposition of various contaminants (including Si, SiO₂, SiOCl, C and AIF) on the reactor wall during the plasma process. For avoiding parameter drifts, the reactor chamber is regularly cleaned (generally between each wafer processing) by using cleaning plasmas such as SF₆/O₂ plasmas, CF₄ plasmas, O₂ plasmas, chlorinated plasmas, and others. After the cleaning step, either a wafer processing is directly run in the clean chamber, or sometimes the chamber is in addition "conditioned" (coated by a polymer film) by another plasma. In the latter case, after processing each wafer, both the contaminant formed on the polymer coating and the polymer itself must be cleared from the reactor walls by a cleaning plasma to reset the reactor under reproducible conditions.

In practice, parameters drifts appear when a same reactor is used in conditions that are theoretically identical. So, semiconductor manufacturers commonly use test wafers that are, from time to time, introduced in the plasma reactor and checked for controlling the plasma parameters. An important factor of variation of the plasma parameters is due to the deposition of various contaminants, including Si and SiO₂, on the reactor walls. For avoiding parameter drifts, the reactor chamber is regularly cleaned, for example, by using cleaning plasmas, such as O₂ plasmas, chlorinated plasmas, SF₆/O₂ plasmas, and others. However, the optimal conditions of a cleaning are not well known, and often, to be on the safe side, the manufacturer prefers making very long cleaning steps that can be unuseful and possibly harmful.

The use of test wafers is time consuming and the test wafers are costly. Also the use of non optimized cleaning steps is time consuming.

An object of the invention is to alleviate one or more drawbacks of conventional methods of use of plasma reactors.

Another object of the invention is to provide a method avoiding the use of reference wafers and/or long cleaning steps.

Another object of the invention is to provide a method for checking with precision the state of a plasma reactor.

Another object of the invention is to use such a method for optimizing the cleaning process of a plasma reactor.

Another object of the invention is to use such a method to check that two reactors of the same model are really identical and, if not, to match the reactors.

To achieve part or all of these objects, the present invention provides a method of testing a plasma reactor comprising:
a) introducing Cl₂,
b) creating a plasma,
c) after the plasma creation, measuring the absolute Cl₂ concentration,
d) comparing the measured Cl₂ concentration with a reference Cl₂ concentration.

Then, the result of the comparison is used for checking that the plasma reactor is in a standard state. If not, various correcting operations can be implemented by the reactor operator. For example, the reactor is cleaned and possibly conditioned again and steps a) to d) are repeated. The test method according to the invention can be in particular used for determining optimized minimum cleaning or cleaning-conditioning operations.

The test method according to the invention is preferentially implemented before introducing a wafer in the reactor.

Preferentially, the Cl₂ concentration measuring step comprises measuring the absorption of an UV ray across the plasma.

Preferentially, the concentration measurement is scaled by making the ratio between the intensity of the beam crossing the plasma and of a beam reflected before having crossed the plasma reactor.

Preferentially, each of the steps a) to c) has a duration comprised between 1 and 5 seconds and yet preferentially comprised between 1 and 3 seconds.

In an embodiment of the invention, the Cl₂ reference concentration corresponds to the concentration of Cl₂ measured at step c), while steps a) to c) are implemented immediately after a preliminary thorough cleaning of the plasma reactor, this cleaning being possibly followed with a conditioning step.

The present invention also provides a plasma reactor comprising opposite UV-transparent windows, means for introducing an UV beam through one window, and means for collecting the beam having crossed the plasma and issuing from an opposite window.

The foregoing and other objects, features and advantages of the present invention will be discussed in detail in the following non limiting description of specific embodiments in connection with the accompanying drawings, in which:
figure 1 illustrates the absorption features in various operating states of a plasma reactor; and
figure 2 shows a plasma reactor equipped for implementing the method according to an embodiment of the invention.

The invention proposes using the variation of the Cl₂ concentration in a Cl₂ plasma as a test of the state of a plasma reactor.

"Effect of chamber wall conditions on Cl and Cl2 concentrations in an inductively coupled plasma reactor" by Saurabh J. Ullal et al., J. Vac. Sci. Technol., A 20(1), Jan/Feb. 2002, pp 43-52, is an example of a document indicating that the wall conditions of a plasma chamber have an influence on Cl and Cl₂ concentrations.

This article suggests measuring the Cl₂ concentration by an optical emission spectroscopy method associated with an actinometry method. It results from the various drawings and indications given in this article that the precision of the measurement is not better than 1%. Also, in this article, as shown for example in figure 9, it is assumed that, after a cleaning, a plasma reactor is in perfect condition.

The present invention proposes to use the variations of the Cl₂ concentration in a Cl₂ plasma to test the cleanliness/conditioning of a "clean/conditioned" plasma reactor. The invention provides for measuring with a great precision, in the range of 1/1000 or better, the concentration of Cl₂ in a plasma of Cl₂ and the inventors have shown that the result of this measurement is a good indication of the state of a plasma reactor. In particular, the cleaning of a plasma reactor chamber is considered as optimum when a measurement made after a standard cleaning is sufficiently close from a measurement made after a thorough cleaning of the chamber.

More specifically, the invention provides, before each use of a plasma reactor, to create a Cl₂ plasma; a short time, for example some seconds, after the plasma creation, to measure the Cl₂ concentration in the plasma reactor chamber, and to compare the measured Cl₂ concentration with a reference Cl₂ concentration. According to the invention, the variation of the Cl₂ concentration is a good indicator of the state of the plasma reactor chamber. It can be used, for example to decide whether additional cleaning/conditioning steps must be undertaken. By implementing after each run of the process minimum cleaning steps, the operator will be able to define an optimum cleaning process.

To obtain a precise measurement (better than 1/1000), methods based on the detection of emitted radiation are not satisfactory and the inventors propose to use an absorption method, wherein the absorption I of a radiation absorbed by Cl₂ molecules but not by Cl atoms or ions is measured. Therefore, the absorption of the radiation is proportional to the absolute concentration of Cl₂ in the reactor.

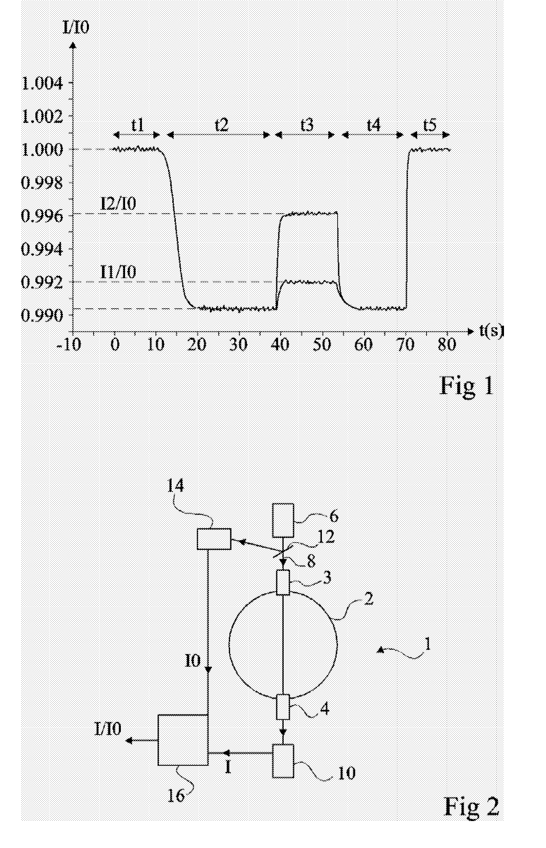

Figure 1 illustrates measurements of the absorption of an UV beam (having for example a wavelength comprised between 260 nm and 440 nm, and preferentially close to 330 nm) by Cl₂ in a plasma reactor chamber in successive steps. The ordinates indicate the scaled intensity I/I0 of an absorption measurement. The abscissae represent the time in seconds.

During a first step, t1, the reactor is evacuated; the scaled intensity I/I0 is equal to 1. During a second step, t2, Cl₂ is introduced in the reactor at a pressure of 40 mtorr (about 5,3 Pa); I/I0 is equal to 0.9905. During a third step, t3, a plasma is formed in the reactor; I/I0 is equal to 0.9920 in a first experiment and to 0.9962 in a second experiment. During a fourth step, t4, the plasma is interrupted; I/I0 is again equal to 0.9905. During a fifth step, t5, the reactor is again evacuated; I/I0 is again equal to 1.

It has been observed by the inventors that, during time t3, I/I0 was equal to a first value I1/I0 = 0.9920 when the reactor was "clean", and to a second value I2/I0 = 0.9962 when the reactor was "dirty", i.e. not perfectly clean. As it can be seen from the drawing, the variations of the pressure of Cl₂ are less than 5/1000 and should be preferentially measured with a precision better than 1/1000.

Having thus a good image of the state of the reactor, it is possible, after each test, to decide whether, for example, the reactor must be cleaned/conditioned again or not. This method can also be used initially to determine the minimum useful duration of the cleaning/conditioning steps.

It should be noted that the invention assumes a very accurate measurement of the Cl₂ pressure in a plasma reactor, in various states of this reactor, and in particular the emission methods disclosed in the above-cited document are not precise enough to show up the phenomenon observed and used by the inventors.

Looking at the time scale of figure 1, it should be noted that each step of the process of the invention can be in the range of some seconds, for example 1 to 5 seconds, preferentially 1 to 3 seconds or less. Accordingly, the whole process of the present invention can be implemented in a very short time with comparison to a conventional process.

Figure 2 very schematically shows a plasma reactor 1 equipped according to the invention. This plasma reactor comprises a plasma chamber 2 provided with facing windows 3 and 4, the windows being in a material transparent to UV radiations. An UV source 6 is arranged in front of the first window 3, so that the emitted beam 8 passing through windows 3 and 4 crosses a region of the reactor chamber wherein the plasma is formed. A detector 10, arranged in front of the second window 4, provides the intensity 10 of the beam partially absorbed by the mixture contained in the plasma reactor, and more particularly by the Cl₂ molecules of this mixture. Preferentially, as shown in figure 2, a portion of the incident beam is deviated by a beam splitter 12 towards a second detector 14 providing an I0 measurement. A comparator 16 is provided and adjusted so as to provide a value 1 of I/I0 in the absence of gas in the chamber.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalents thereto.

## Claims

1. A method of testing a plasma reactor comprising:
a) introducing Cl₂,
b) creating a plasma,
c) after the plasma creation, measuring the Cl₂ concentration,
d) comparing the measured Cl₂ concentration with a reference Cl₂ concentration,
e) if said comparison indicates a deviation higher than a selected threshold, cleaning and possibly conditioning the reactor and repeating steps a) to d).

2. The method of claim 1, implemented before introducing a wafer in the reactor.

3. The method of claim 1, wherein the Cl₂ concentration measuring step comprises measuring the absorption of an UV ray across the plasma.

4. The method of claim 3, wherein the concentration measurement is scaled by making the ratio between the intensity of the beam crossing the plasma and of a beam reflected before having crossed the plasma reactor.

5. The method of claim 1, wherein each of the steps a) to c) has a duration comprised between 1 and 5 seconds.

6. The method of claim 5, wherein each of the steps a) to c) has a duration comprised between 1 and 3 seconds.

7. The method of claim 1, wherein the Cl₂ reference concentration corresponds to the concentration of Cl₂ measured at step c), while steps a) to c) are implemented immediately after a preliminary thorough cleaning and possibly conditioning of the plasma reactor.

8. A plasma reactor comprising opposite UV-transparent windows, means (6) for introducing an UV beam (8) through one window (3), and means (10) for collecting the beam having crossed the plasma and issuing from an opposite window (4).

9. A plasma reactor according to claim 8, further comprising means (16) for scaling the absorbed beam, proportionally to the input scan.

10. A plasma reactor according to claim 8, wherein said UV beam is at a wavelength comprised between 260 and 440 nm.
